# EUROPEAN PATENT SPECIFICATION

(11) **EP 0 476 029 B1**
(45) Date of publication and mention of the grant of the patent: **28.09.1994**
(21) Application number: 90909496.3
(22) Date of filing: 01.06.1990
(51) Int. Cl.: H05K 13/08, G01N 1/28

(54) **METHOD FOR CUTTING PRINTED BOARDS FOR EXAMINATION OF THE PLATING RESULT ON THE WALLS IN HOLES ARRANGED IN THE BOARD**
VERFAHREN ZUM SCHNEIDEN VON GEDRUCKTEN LEITERPLATTEN ZUR PRÜFUNG DER BESCHICHTUNG AN DEN WÄNDEN DER BOHRUNGEN DER PLATTE
PROCEDE DE COUPE DE CARTES DE CIRCUIT IMPRIME PERMETTANT L'EXAMEN DE LA METALLISATION OBTENUE SUR LES PAROIS SITUEES DANS DES TROUS AGENCES DANS LA CARTE

(30) Priority: 08.06.1989 SE 8902068
(43) Date of publication of application: 25.03.1992
(73) Proprietor: HESSELGREN, Tore, S-130 35 Ingarö (SE)
(72) Inventor: HESSELGREN, Tore, S-130 35 Ingarö (SE)
(74) Representative: Onn, Thorsten
(86) International application number: SE9000383
(87) International publication number: WO9015519

(56) References cited:
- DK-B- 125 217
- SE-A- 8 703 100
- US-A- 4 592 138

## Description

The present invention relates generally to processing of printed boards and specifically to a method for cutting printed boards for examination of the plating result on the inner walls of the holes which are made in the board.

In connection with fabrication of printed boards the forming of the holes therein is an important detail. As is well known these holes have a metallized layer on their inner walls and this metallization can suitably be done by plating. A large problem in this connection is to get this plating even and fully covering and the plating result has therefore to be very closely examined.

It has previously been tried to solve this examination problem in different ways. In order to get a good measuring result with negligible errors it is necessary, with for example a hole diameter of 0.2 mm, that the cut lies better than +-0.02 mm. The most common way is to mould sample holes in plastic and grind a plane along a hole diameter. The plating thickness can thus be measured and the quality can be estimated. The disadvantage of this method is mainly a bad accuracy and that it requires considerable amounts of plastic, of which the major part has to be ground away, which is both time consuming and expensive. The Danish patent DK-B-125217 describes the principle of moulding a sample, which should be accurately ground for structure examination, in some form of solidifying mass for later fixing in a retainer with holes. This is then made by means of special cooperating ribs. Also here the needed amount of material is considerable. U S patent US-A-4592138 describes an improvement of said principle, where the samples are in form of round disks or plates which are placed in a retainer and fixed therein, the retainer then being filled with plastic material which solidifies. Milling and grinding is then made to an extent that the hole metallization is exposed along a suitable cut in order to permit examination. This method needs a considerably less amount of plastic material than the previously mentioned methods but is nevertheless relatively slow.

The present invention describes quite another type of solution of the cutting and the control of hole plating in connection with printed boards. The drawbacks in connection with the previously mentioned solutions are eliminated and it is possible to quickly and simply perform necessary controls with an accuracy better than +- 0.002 mm in connection with for example an above mentioned hole diameter of 0.2 mm.

In principle the present invention means that an arbitrary part of a processed material is mounted and worked up in a suitable work-up equipment with exact repetition accuracy, whereby a cut plane is provided the edge of which becomes a calibration reference for an adjustment equipment for selection of cut planes in following work-ups. This and other characteristics of the invention are better stated in the following specification and claims.

The invention will now be described more in detail in connection with a practical embodiment of an equipment, which can put into practice the subject invention, and in connection with the following drawings, where
figure 1 illustrates a sample and attached retainer,
figure 2 illustrates the retainer with a sample mounted in a conveyor,
figures 3A and 3B illustrate a grinding equipment for processing the sample in the retainer,
figure 4 illustrates an adjustment/examination equipment,
figures 5 and 6 illustrate the adjustment of the conveyor in the adjustment/examination equipment,
figure 7 illustrates the conveyor with a new sample in adjusted position,
figure 8 illustrates the conveyor with a ground sample for examination,
figures 9, 10, 11 show various ways of fixing a sample on a carrier for grinding of layers.

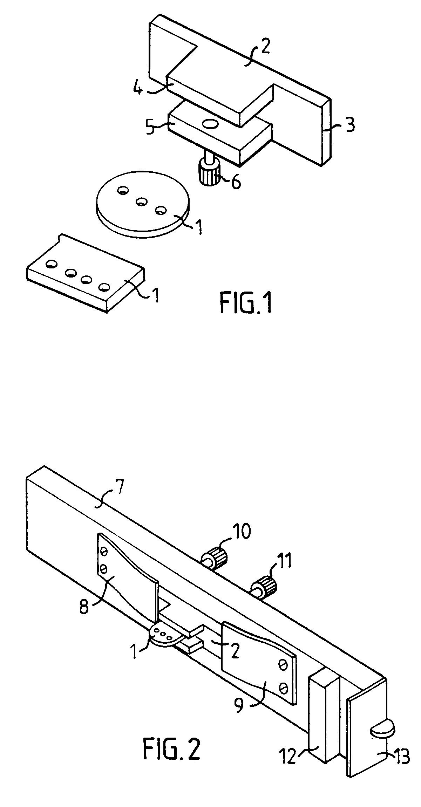

The method according to the invention will now be described in logical sequence. The first step is to provide a calibration of the equipment to be used. For this purpose a first sample is provided. This can have arbitrary form and be of arbitrary material, the only condition is that it has to be processable in the equipment to be used. From a practical point of view it can be suitable to provide this sample from a pr ted board and the sample may then be round or square with or without holes. Figure 1 examplifies such a sample of round and square form and with reference number 1. This sample is then mounted in a retainer 2, which can consist of a main part 3 with two extending parts 4,5 with such mutual distance that the sample can be positioned therebetween and fixed by means of a screw 6. This mounting needs no precision, only that the sample is properly fixed.

The retainer with the sample is then mounted in a conveyor 7, figure 2. This conveyor is provided with two spring sheets 8, 9, the retainer being inserted between these leaves and the main part of the conveyor and fixed by means of two adjustment screws 10, 11 in order to be firmly positioned. Nor does this mounting need any special precision. Further the conveyor is at the one end provided with control means 12, 13 for engagement with a device in form of a guide rail in the grinding equipment to be used.

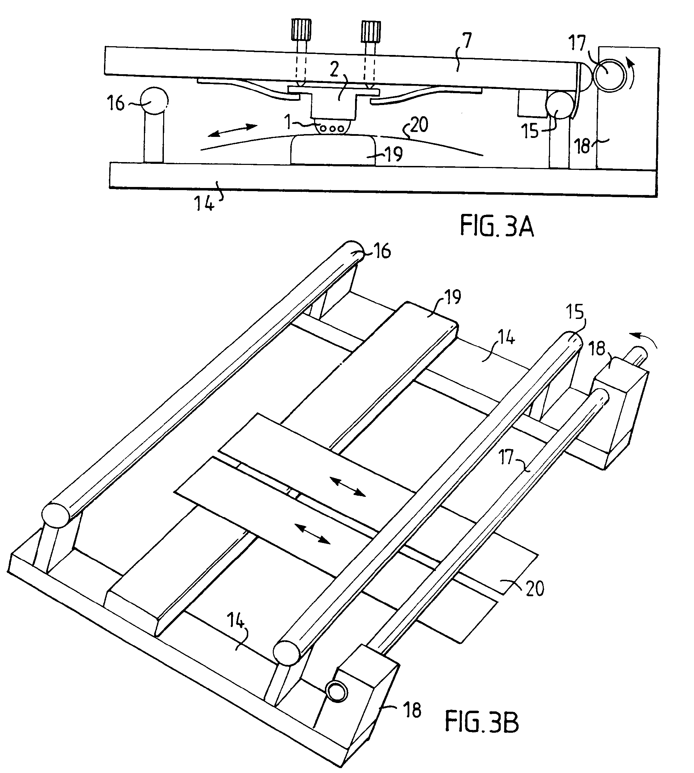

Figures 3A and 3B illustrate the grinding equipment, where figure 3A shows the equipment from one side with engaged conveyor and figure 3B shows the equipment in perspective with the conveyor removed for clarification purposes. The grinding equipment comprises a supporting lower part 14 supporting two guide rails 15, 16, an extending screw 17 in suitable mounting 18 cooperating with the conveyor and a frame 19 for the grinding means, in this case a grinding paper 20.

The conveyor 7 with the first sample 1 in the retainer 2 is inserted in the grinding equipment for providing a cut surface or cut plane on this first sample. The grinding equipment is formed in such a way that the conveyor 7 engages and presses against one of the guide rails 15 at the end provided with control means. The conveyor is revolving around and displaceble along this guide rail, see fig. 3A, the sample 1 then coming to rest on a grinding paper 20 moving to and fro which paper will work up the material in this sample until the conveyor 7 drops down at its other end to contact with the second guide rail 16. The conveyor can by means of the screw 17 be displaced along the guide rails 15, 15 to possible further grinding stations, see fig. 3B. Every following grinding station is always arranged somewhat higher than the preceding one and therefore the grinding at a following station will be done in the same way as in the preceding case until the free end of the conveyor 7 again reaches the guide rail 16. The mechanics for the grinding paper movement, for the lifting up of the conveyor at the guide rail 16 under movement between grinding stations and how the height of the grinding paper is slightly increased between the grinding stations constitutes no part of the subject invention and has therefore not been shown.

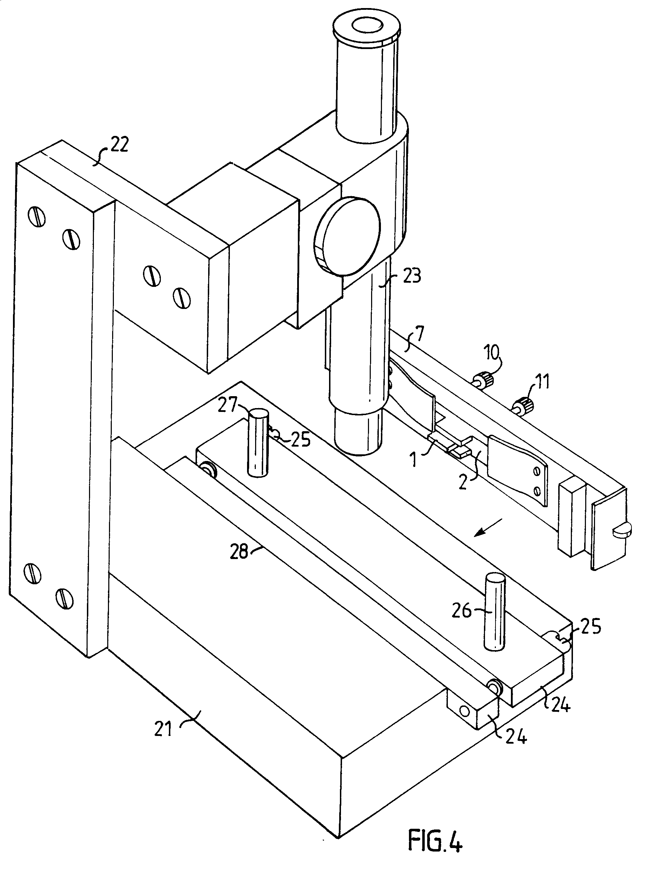

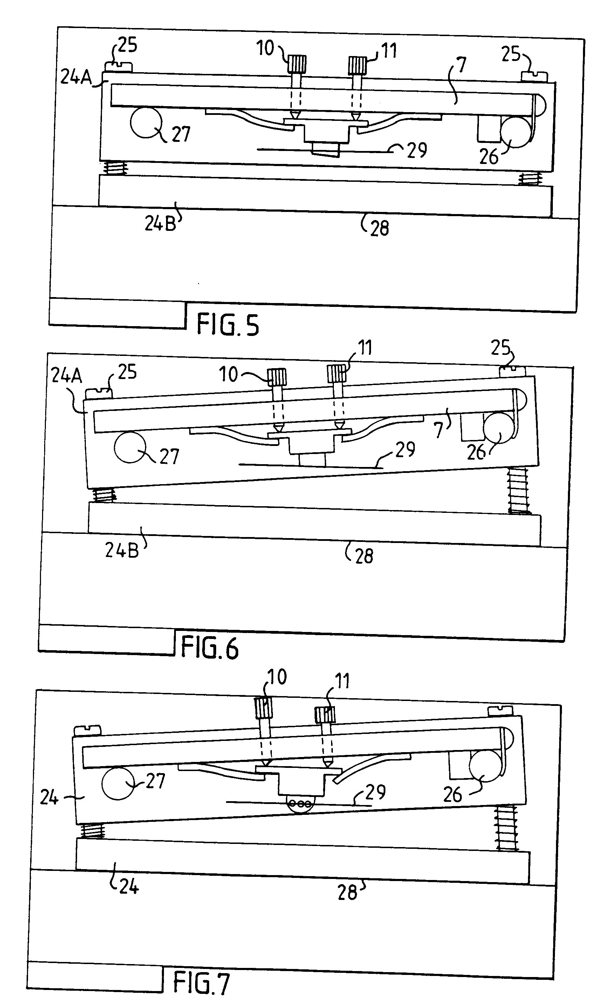

Figure 4 shows the adjustment/examination equipment. This equipment comprises in principle a basic part 21, which by means of suitable brackets 22 supports a microscope 23. The basic part further supports a slide 24 provided with screws 25 for adjustment of the reference line 29 of the adjustment/examination equipment (figs. 5, 6, 7, 8) so that it coincides in the microscope with the edge of the ground surface obtained at the first grinding process. This adjustment can of course be made only after the conveyor 7 with fixed retainer 2 and sample 1 has been placed in the adjustment/examination equipment. The latter is for this purpose equiped with two pins 26 and 27 which are located on the equipment slide 24. The slide is divided in two parts which can be adjusted relative to each other by means of the screws 25. The pins 26 and 27 are placed at the same mutual distance as the guide rails 15 and 16 in the grinding equipment.

Figures 5 and 6 show the conveyor 7 placed on the adjustment/examination equipment slide 24 and seen from above. As can be seen the slide is divided in two parts, 24A and 24B, the conveyor being fixed on the part 24A which is provided with the pins 26 and 27. Both parts of the slide are separated by means of two compressed coil springs which are arranged on the adjustment screws 25. By influencing these screws the part 24A can be displaced and turned in angle relative to part 24B, which is slideble along a slide face 28. By this change of position of part 24A the adjustment of the conveyor and also the sample is changed in a corresponding way and can be adjusted exactly relative to the reference line 29 of the adjustment/examination equipment. Figure 6 shows how the conveyor with fixed sample has been turned by means of screws 25 such that the cut surface of the sample coincides with the reference line 29. It should be noted that the angle turning has been very much exaggerated. In practice it deals with very small angles. The adjustment/examination equipment is now set according to the cutting result which has been achieved in the grinding equipment and which repetitively will be achieved.

A second sample 1, now with a row of holes to be ground through a suggested centrum line, is fixed in the retainer 2, which is fixed in the conveyor 7. The conveyor placed in the adjustment/examination equipment has now the position which has been previously set and the suggested centrum line of the row of holes can by means of the screws 10 and 11 in the conveyor be oriented to the reference line 29 of the adjustment/examination equipment. If then the holes can not be observed simultaneously the slide 24 is moved along the slide surface 28 which is parallel to the reference line 29.

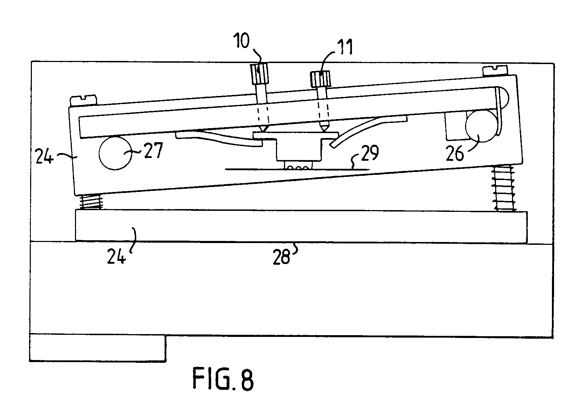

Thereafter the conveyor is inserted in the grinding equipment and the exposed cut surface, which always has the same position relative to the guide rails 15, 16, will now coincide with the reference line 29 of the adjustment/examination equipment, which easily can be controlled by again placing the conveyor in the adjustment/examination equipment for control after terminated grinding. This is best shown in figure 8. After control of the cut result the conveyor can be turned a quarter of a turn and then the microscope in the adjustment/examination equipment can be used for examination of the plating result along the edges of the holes.

Due to the extreme accuracy of this method a ground cut surface can, in order to make transillumination possible for contrast reasons, be cemented on a transparent material and a new cutting can be performed at the distance of for example 10 my from the previous cut surface and therefore a thin layer of the original sample remains with a thickness of 10 my.

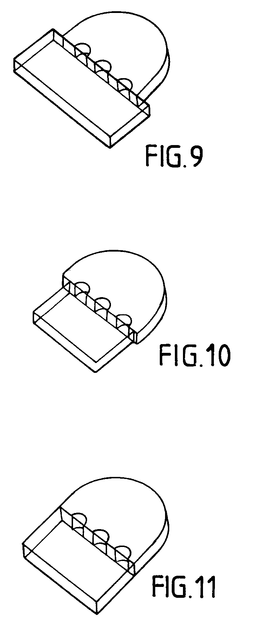

In order to obtain a reference line as identificable as possible for setting of this second grinding the transparent carrier can according to figure 9 be made somewhat longer at the same time as the cement layer is made very thin. Adjustment is now made on each side of the cemented sample.

Alternatively according to figure 10 the transparent carrier can be made somewhat shorter than the sample in which case the setting is made on the two extending sides of the sample.

Alternatively, the outer edges of the ground cut surface may according to fig. 11 be coloured.

The representation of the reference line can be varied in a number of ways.

For obtaining a still thinner layer the transparent carrier is suitably first ground in the grinding equipment and then the sample, which should be processed, is cemented on the carrier when still in the retainer in the conveyor for a later "back adjusting" of the retainer by means of the adjustment screws 10 and 11 exactly the number of my which is desired to be left after further grinding.

An alternative to grinding are other processing methods, for example with diamond blade, laser, water-jet cutting etc.

As an alternative to microscope a manually or automatically handled photocell equipment may be used.

## Claims

1. Method for cutting printed circuit boards for examination of the plating result on the walls in holes arranged in the board, **characterized** by the following steps:
- producing a first sample (1) from a printed circuit board and fixing the same in a retainer (2), which is adjustably mounted in a conveyor (7),
- insertion of the conveyor (7) with the sample in the retainer (2) in a processing device for providing a desired cut plane on the sample (1),
- placing the conveyor (7) with the cut sample in an adjustment/examination equipment,
- adjusting the position of the conveyor (7) in the adjustment/examination equipment for orientation of the edge of the provided cut plane in line with a reference line (29) of the equipment, said edge becoming the calibration reference for the equipment for selection of cut planes in following processes,
- fixing of a new sample (1) in the retainer (2) so that the desired cut coincides with the reference line (29) of the adjustment/examination equipment and providing a cut plane in the processing device in previously described manner, and
- placing the conveyor with the new cut sample in the retainer in the adjustment/examination equipment, where the edge of the newly exposed cut plane will coincide with the reference line of the adjustment/examination equipment.

2. Method according to claim 1, **characterized** by all the following samples (1) being handled in the same way as said first sample, whereby every exposed cut plane by means of the adjustment of the retainer (2) and the adjustment/examination equipment in connection with the first processed sample will coincide with the reference line (29) of the adjustment/examination equipment.

3. Method according to claims 1-2, **characterized** by the adjustment/examination equipment continuously being adapted to possible wear of the equipment.

4. Method according to claims 1-3, **characterized** by that the generation of a cut plane on the samples is done by grinding.

## Patentansprüche

1. Verfahren zum Aufschneiden von Printplatten zwecks Prüfung der Metallisierungsergebnisse an den Wandungen von Löchern in der Platte, gekennzeichnet durch die folgenden Schritte:
- Erstellung einer ersten Probe (1) einer Printplatte und deren Befestigung in einem Halter (2), der einstellbar in einer Transportvorrichtung (7) angebracht ist,
- Einsetzen der Transportvorrichtung (7) zusammen mit der Probe im Halter (2) in eine Bearbeitungsvorrichtung zur Erzeugung einer gewünschten Schnittebene an der Probe (1),
- Plazierung der Transportvorrichtung (7) mit der Schnittprobe in einer Einrichtung zum Einstellen/Prüfen,
- Ausrichten der Stellung der Transportvorrichtung (7) in der Einrichtung zum Einstellen/Prüfen zwecks Orientierung der Kante der erzeugten Schnittebene auf eine Bezugslinie (29) der Einrichtung, wobei die genannte Kante zur Kalibrierungs-Bezugsgrösse der Einrichtung zwecks Wahl von Schnittebenen in nachfolgenden Verfahren wird,
- Befestigung einer neuen Probe (1) im Halter (2), derart, dass der gewünschte Schnitt mit der Bezugslinie (29) der Einrichtung zum Einstellen/Prüfen zusammenfällt, und Erzeugung einer Schnittebene in der Bearbeitungsvorrichtung auf die vorstehend beschriebene Art, und
- Plazierung der Transportvorrichtung mit der neuen Schnittprobe im Halter in der Einrichtung zum Einstellen/Prüfen, wobei die Kante der neu blossgelegten Schnittebene mit der Bezugslinie der Einrichtung zum Einstellen/Prüfen zusammenfällt.

2. Verfahren nach Anspruch 1, dadurch gekennzeichnet, dass sämtliche folgenden Proben (1) auf die gleiche Art wie die erste Probe behandelt werden, wobei jede blossgelegte Schnittebene durch die Einstellung des Halters (2) und der Einrichtung zum Einstellen/Prüfen in Verbindung mit der ersten bearbeiteten Probe mit der Bezugslinie (29) der Einrichtung zum Einstellen/Prüfen zusammenfällt.

3. Verfahren nach Anspruch 1 bis 2, dadurch gekennzeichnet, dass die Einrichtung zum Einstellen/Prüfen an eine mögliche Abnutzung der Einrichtung angepasst wird.

4. Verfahren nach Anspruch 1 bis 3, dadurch gekennzeichnet, dass die Erzeugung einer Schnittebene an der Probe durch Schleifen geschieht.

## Revendications

1. Procédé pour découper des plaques à circuits imprimés pour l'examen du résultat de l'électrodéposition sur les parois des trous dans la plaque, caractérisé par les étapes suivantes:
- création d'un premier échantillon (1) à partir d'une plaque à circuits imprimés et fixation de celle-ci dans un support (2) qui est monté de manière ajustable dans un transporteur (7),
- insertion du transporteur (7) comprenant l'échantillon fixé dans le support (2) dans un dispositif de traitement pour produire un plan de découpage désiré dans l'échantillon,
- placement du transporteur (7) comprenant l'échantillon découpé dans un dispositif d'ajustage/examen,
- ajustage de la position du transporteur (7) dans le dispositif d'ajustage/examen afin d'aligner le bord du plan de découpage produit avec une ligne de référence (29) du dispositif, le dit bord devenant la référence d'étalonnage du dispositif pour la sélection des plans de découpage dans les procédés suivants,
- fixation d'un nouvel échantillon (1) dans le support (2) de manière à faire coïncider le découpage désiré avec la ligne de référence (29) du dispositif d'ajustage/examen, et production d'un plan de découpage dans le dispositif de traitement de la manière décrite ci-dessus, et
- insertion du transporteur comprenant le nouvel échantillon découpé fixé dans le support, dans le dispositif d'ajustage/examen où le bord du plan de découpage nouvellement exposé coïncidera avec la ligne de référence du dispositif d'ajustage/examen.

2. Procédé selon la revendication 1, caractérisé en ce que tous les échantillons suivants (1) sont traités de la même façon que le dit premier échantillon, chaque plan de découpage exposé coïncidant avec la ligne de référence (29) du dispositif d'ajustage/examen grâce à l'ajustage du support (2) et au dispositif d'ajustage/examen en combinaison avec le premier échantillon travaillé.

3. Procédé selon les revendications 1 à 2, caractérisé en ce que le dispositif d'ajustage/examen est adapté en continu à une usure possible du dispositif.

4. Procédé selon les revendications 1 à 3, caractérisé en ce que la production d'un plan de découpage sur l'échantillon est effectuée par meulage.
